# EUROPÄISCHE PATENTSCHRIFT

(11) **EP 0 800 711 B1**
(45) Veröffentlichungstag und Bekanntmachung des Hinweises auf die Patenterteilung: **14.02.2001**
(21) Anmeldenummer: 96934287.2
(22) Anmeldetag: 24.10.1996
(51) Int. Cl.: H01R 12/08, H01R 12/24

(54) **VERFAHREN UND ANORDNUNG ZUM DURCHSCHALTEN EINER MEHRZAHL VONEINANDER DISTANZIERTER ELEKTRISCHER KONTAKTSTELLEN**
PROCESS AND ARRANGEMENT FOR CONNECTING A PLURALITY OF MUTUALLY REMOTE ELECTRIC CONTACT POINTS
PROCEDE ET DISPOSITIF POUR L'INTERCONNEXION D'UNE PLURALITE DE POINTS DE CONTACT ELECTRIQUES ELOIGNES ENTRE EUX

(30) Priorität: 26.10.1995 CH 302495
(43) Veröffentlichungstag der Anmeldung: 15.10.1997
(73) Patentinhaber: Reichle + De-Massari AG Elektro-Ingenieure, 8620 Wetzikon (CH)
(72) Erfinder: REICHLE, Hans, CH-8620 Wetzikon (CH)
(74) Vertreter: Petschner, Goetz
(86) Internationale Anmeldenummer: CH9600375
(87) Internationale Veröffentlichungsnummer: WO9715965

(56) Entgegenhaltungen:
- EP-A- 0 339 701
- EP-A- 0 437 296
- EP-A- 0 443 655
- GB-A- 2 258 957
- IBM TECHNICAL DISCLOSURE BULLETIN, Bd. 30, Nr. 6, November 1987, Seiten 349-350, XP002022996 "Flexible circuits as connectors"

## Beschreibung

Die vorliegende Erfindung betrifft eine Kontakt-Vorrichtung insbesondere einen Zwischenstecker, mit einer Mehrzahl voneinander distanzierten und durchgeschalteten elektrischen Stecker- und/oder Buchsen-Kontaktstellen, wobei das Durchschalten mittels bandförmiger, biegefähiger Leiterbahn-Folien mit einer Mehrzahl von wenigstens teilweise parallelen Leiterbahnen erfolgt.

Eine solche Anordnung ist durch die EP-A-0 443 655 bekanntgeworden.

Um nun eine solche Anordnung zu verbessern, derart, dass voneinander distanzierte Kontaktstellen intern auf möglichst kurzem Wege möglichst kreuzungsfrei und mit geringster kapazitiven Kopplung sowie möglichst lötfrei verbunden werden können, sind erfindungsgemäss Leiterbahnen-Abschnitte im Steckbereich der elektrischen Stecker- und/oder Buchsen-Kontaktstellen freigelegt und bilden direkte Steck-Kontakte.

Hierbei ist es vorteilhaft, wenn die die Steck-Kontakte bildenden Leiterbahnabschnitte wenigstens teilweise unter der Wirkung von Kontaktdruck erzeugenden Federmitteln stehen und wenn die Leiterbahnen wenigstens in den Steckbereichen durch Rippen aus Kunststoff voneinander getrennt gehalten werden

Zudem ist es wesentlich, dass die Leiterbahnen an beliebiger Stelle ausgekreuzt werden können, wofür die Leiterbahn-Folie mit mindenstens einer seitlichen Abragung mit weiteren querverlaufenden Leiterbahnen und /oder die Leiterbahn-Folie mit einem, die parallelen Leiterbahnen wenigstens teilweise untereinander verbindenden, vorzugsweise drehbaren Schleifring versehen wird.

Weiter können für eine Auskreuzung die parallelen Leiterbahnen durch Querstege miteinander verbunden sein, um durch beliebige Unterbrechungen der Leiter an beliebigen Orten unterschiedliche Schaltungswege zu erzielen.

Beispielsweise Ausführungsformen des Erfindungsgegenstandes sind nachfolgend anhand der Zeichnung näher erläutert. Es zeigen:
- Fig. 1: in schaubildartiger Darstellung die erfindungsgemässe Anschluss-Vorrichtung zur Erläuterung des erfindungsgemässen Verfahrens zum Durchschalten einer Mehrzahl voneinander distanzierter elektrischer Kontaktstellen;
- Fig. 2: in schaubildartiger Darstellung eine biegefähige Leiterbahn-Folie mit einer Mehrzahl wenigstens teilweise parallelen Leiterbahnen zur Durchführung des erfindungsgemässen Verfahrens; und
- Fig. 3, 4 + 5: Ausführungsvarianten von biegefähigen Leiterbahn-Folien.

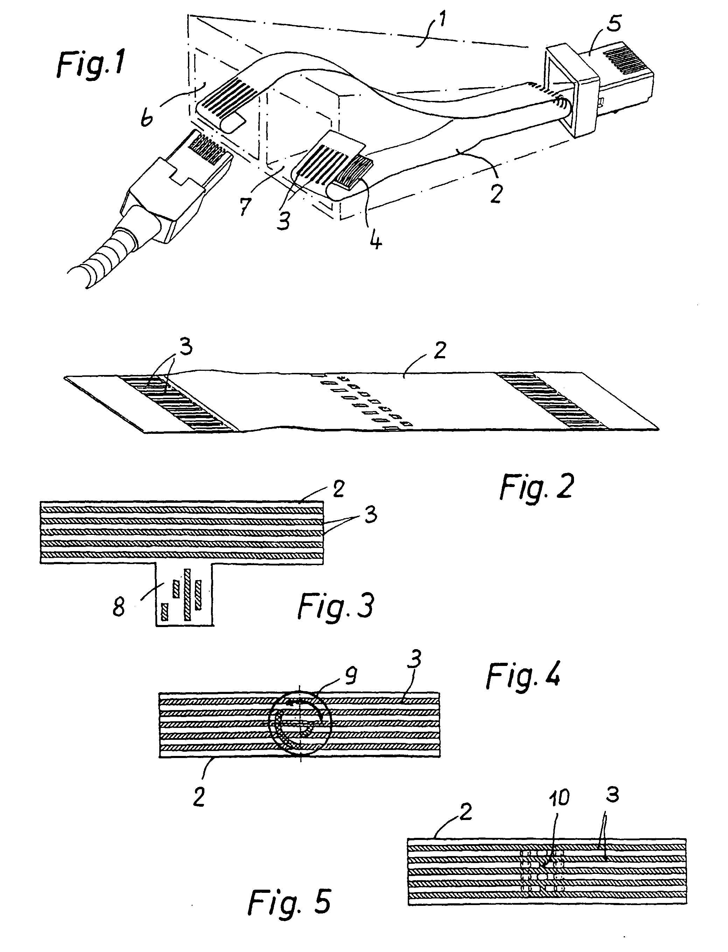

Bei der in Fig. 1 schematisch angedeuteten Anschluss-Vorrichtung 1, hier in Form eines Doppel-Adapters, erfolgt das Durchschalten der voneinander distanzierten elektrischen Kontaktstellen mittels einer bandförmigen, biegefähigen Leiterbahn-Folie 2 mit einer Mehrzahl wenigstens teilweise parallelen Leiterbahnen 3, wobei Leiterbahnen-Abschnitte in Steckbereichen moduler Stecker- und/oder Buchsenmittel 5,6,7 direkte Steck-Kontakte bilden.

Ein solches verfahrensgemässes Durchschalten einer Mehrzahl voneinander distanzierter elektrischer Kontaktstellen mittels bandförmiger, biegefähiger Leiterbahn-Folie mit einer Mehrzahl wenigstens teilweise parallelen Leiterbahnen gestattet, voneinander distanzierte Kontaktstellen intern auf kürzestem Wege kreuzungsfrei und mit geringster kapazitiven Kopplung sowie lötfrei zu verbinden.

Hierfür besteht die Leiterbahn-Folie 2 aus einem elektrisch nicht leitenden, mit den Leiterbahnen 3 versehenen Trägermaterial, wobei die einzelnen Leiterbahnen im vorgesehenen Kontaktbereich durch Ätzen oder auf mechanischem Wege oder Nichtbedecken freiliegen.

Um dann Kontaktschluss zwischen benachbarten Leiterbahnen zu verhindern, können die freiliegenden Leiterbahnen durch Rippen aus Kunststoff voneinander getrennt gehalten werden (nicht gezeigt).

Wie Fig. 1 zeigt, kann eine solche Leiterbahn-Folie durch entsprechendes Falten und/oder Verdrehen die verschiedensten Kontaktbereiche miteinander verbinden, hier beispielsweise eine Steckerseite 5 mit zwei Buchsenseiten 6 und 7.

Für einen ausreichenden Kontaktdruck auf die relativ kleinen Leiterflächen ist es zudem wesentlich, wenn die freigelegten Leiterbahnen wenigstens teilweise unter der Wirkung von Kontaktdruck erzeugenden Federmitteln stehen, wie das in Fig. 1 durch einen Federkamm 4 angedeutet ist.

Wie weiter die Fig. 3,4 und 5 zeigen, können weitere Ausgestaltungen betreffend Vielfalt der Aufschaltungsmöglichkeiten, insbesondere durch Auskreuzung der Leiterbahnen darin gesehen werden, dass die Leiterbahn-Folie 2 mit mindenstens einer seitlichen Abragung 8 mit weiteren querverlaufenden Leiterbahnen versehen wird, oder die Leiterbahn-Folie mit einem, die parallelen Leiterbahnen wenigstens teilweise untereinander verbindenden, vorzugsweise drehbaren Schleifring 9 versehen wird, oder die parallelen Leiterbahnen 3 durch Querstege 10 miteinander verbunden werden

Durch die vorbeschriebenen Massnahmen ist es nunmehr möglich, voneinander distanzierte Kontaktstellen intern auf kürzestem Wege und mit geringster kapazitiven Kopplung sowie lötfrei zu verbinden wobei sich eine grosse Anzahl von Aufschaltungsvarianten ergibt.

Weiter können für einen variablen Aufbau entsprechender Adapter u. dgl. Leiterbahnabschnitte über Kontaktmittel, wie Stifte u. dgl., in eine andere Kontaktebene übergeführt werden.

## Patentansprüche

1. Kontakt-Vorrichtung, insbesondere einen Zwischenstecker, mit einer Mehrzahl voneinander distanzierten und durchgeschalteten elektrischen Stecker- und/oder Buchsen-Kontaktstellen (5, 6, 7), wobei das Durchschalten mittels bandförmiger, biegefähiger Leiterbahn-Folien (2) mit einer Mehrzahl von wenigstens teilweise parallelen Leiterbahnen (3) erfolgt,
dadurch gekennzeichnet,
dass Leiterbahnen-Abschnitte im Steckbereich der elektrischen Stecker- und/oder Buchsen-Kontaktstellen (5, 6, 7) freigelegt sind und direkte Steck-Kontakte bilden.

2. Kontakt-Vorrichtung nach Anspruch 1, dadurch gekennzeichnet, dass die, Steck-Kontakte bildenden Leiterbahnen-Abschnitte wenigstens teilweise unter der Wirkung von Kontaktdruck erzeugenden Federmitteln (4) stehen.

3. Kontakt-Vorrichtung nach Anspruch 1, dadurch gekennzeichnet, dass die, Steck-Kontakte bildenden Leiterbahnen-Abschnitte durch Rippen aus Kunststoff voneinander getrennt sind.

4. Kontakt-Vorrichtung nach Anspruch 1, dadurch gekennzeichnet, dass für eine Auskreuzung der Leiterbahnen die Leiterbahn-Folie mit mindenstens einer seitlichen Abragung mit weiteren querverlaufenden Leiterbahnen versehen ist.

5. Kontakt-Vorrichtung nach Anspruch 1, dadurch gekennzeichnet, dass für eine Auskreuzung der Leiterbahnen die Leiterbahn-Folie mit einem, die parallelen Leiterbahnen wenigstens teilweise untereinander verbindenden, vorzugsweise drehbaren Schleifring versehen ist.

6. Kontakt-Vorrichtung nach Anspruch 1, dadurch gekennzeichnet, dass für eine Auskreuzung der Leiterbahnen die parallelen Leiterbahnen durch Querstege miteinander verbunden sind.

## Claims

1. A connection device especially adapter plug, comprising a plurality of spaced-apart, through-connected male and/or female electrical contacts (5,6,7), wherein the through-connection is established by band-shaped flexible printed conductor foils (2) with a plurality of at least partially parallel conductors (3),
characterized in that
printed conductor sections near the plugs of modular plugging and/or socket means (5,6,7) exposed so as to form direct plugged contacts.

2. A connection device as claimed in Claim 1, characterized in that the printed conductor sections which form plugged contacts are subjected to at least some extent to the effects of springs (4) which create contact pressure.

3. A connection device as claimed in Claim 1, characterized in that the printed conductors are held apart by plastic ribs, at least in the plug areas.

4. A connection device as claimed in Claim 1, characterized in that the printed conductor foil is provided with at least one downward projection with additional transverse printed conductors for cross-jointing the printed conductors.

5. A connection device as claimed in Claim 1, characterized in that the printed conductor foil is provided with a preferably swivelable slip ring which connects at least some of the parallel printed conductors for cross-jointing the printed conductors.

6. A connection device as claimed in Claim 1, characterized in that the parallel printed conductors are connected by means of cross bridges for a cross-Joint.

## Revendications

1. Dispositif de contact, notamment fiche intermédiaire, avec une pluralité de points de contact électriques (5, 6, 7), à fiche et/ou prise interconnectés et espacés les uns des autres, où l'interconnexion a lieu au moyen de feuilles de bande conductrice flexibles (2) en forme de bande avec une pluralité de bandes conductrices (3) au moins partiellement parallèles, caractérisé en ce que des sections de bandes conductrices sont mises à nu dans la zone de connexion des points de contact électriques (5, 6, 7) à fiche et/ou prise et forment des contacts de connexion directs.

2. Dispositif de contact selon la revendication 1, caractérisé en ce que les sections de bande conductrice formant les contacts de connexion sont soumises au moins partiellement à l'action de moyens à ressort (4) produisant une pression de contact.

3. Dispositif de contact selon la revendication 1, caractérisé en ce que les sections de bande conductrice formant les contacts de connexion sont séparées les unes des autres par des nervures en matière synthétique.

4. Dispositif de contact selon la revendication 1, caractérisé en ce que, pour un croisement des bandes conductrices, la feuille de bande conductrice est pourvue d'au moins une saillie latérale avec d'autres bandes conductrices s'étendant transversalement.

5. Dispositif de contact selon la revendication 1, caractérisé en ce que pour un croisement des bandes conductrices, la feuille de bande conductrice est pourvue d'une bague de frottement, de préférence tournante, reliant les bandes conductrices parallèles au moins partiellement entre elles.

6. Dispositif de contact selon la revendication 1, caractérisé en ce que pour un croisement des bandes conductrices, les bandes conductrices parallèles sont reliées entre elles par des nervures transversales.
